# EUROPEAN PATENT SPECIFICATION

(11) **EP 3 789 745 B1**
(45) Date of publication and mention of the grant of the patent: **10.04.2024**
(21) Application number: 19196138.2
(22) Date of filing: 09.09.2019
(51) Int. Cl.: G01K 13/00, H01L 23/498

(54) **FLEXIBLE PASSIVE ELECTRONIC COMPONENT AND METHOD FOR PRODUCING THE SAME**
FLEXIBLE PASSIVE ELEKTRONISCHE KOMPONENTE UND VERFAHREN ZUR HERSTELLUNG DAVON
COMPOSANT ÉLECTRONIQUE PASSIF FLEXIBLE ET SON PROCÉDÉ DE PRODUCTION

(43) Date of publication of application: 10.03.2021
(73) Proprietor: Yageo Nexensos GmbH, 63801 Kleinostheim (DE)
(72) Inventor: NEUMANN, Christian, 63450 Hanau (DE); ASMUS, Tim, 63450 Hanau (DE); DIETMANN, Stefan, 63450 Hanau (DE); NICK, Christoph, 63450 Hanau (DE)
(74) Representative: Meissner Bolte Partnerschaft mbB

(56) References cited:
- US-A1- 2009 008 132
- US-A1- 2012 112 347
- US-A1- 2017 127 944
- Jiang Shui-Dong ET AL: "Microfabrication of thin film temperature sensor for cryogenic measurement", MICROSYSTEM TECHNOLOGIES, vol. 20, no. 3, 1 March 2014 (2014-03-01), pages 451-456, XP093040038, DE ISSN: 0946-7076, DOI: 10.1007/s00542-013-1982-x Retrieved from the Internet: URL:https://link.springer.com/content/pdf/ 10.1007/s00542-013-1982-x.pdf?pdf=button>
- Jiang Shui-Dong ET AL: "Microfabrication of thin film temperature sensor for cryogenic measurement", MICROSYSTEM TECHNOLOGIES, vol. 20, no. 3, 1 March 2014 (2014-03-01), pages 451-456, XP93040038, DE ISSN: 0946-7076, DOI: 10.1007/s00542-013-1982-x Retrieved from the Internet: URL:https://link.springer.com/content/pdf/ 10.1007/s00542-013-1982-x.pdf?pdf=button>

## Description

### Technical field

The invention relates to a flexible passive electronic component, in particular to a sensor measuring the change in electric resistance caused by external impacts such as temperature, gas absorption, chemical reactions, particle flow, light input and force input. The flexible passive electronic component has an electrical structure in which the electric resistance of the electrical structure changes by the external input. The electrical structure is provided on a substrate. The invention also relates to a method for producing the flexible passive electronic component, especially the sensor.

### Background art

A temperature sensor is an example of such a sensor. Currently used thin-film temperature sensors with a positive temperature coefficient are based on a flat metal layer applied to a substrate. With a temperature change ΔT, the electrical resistance of the metal sheet R(T) changes according to R(T) = R(0)·(1 + ξ(T)·ΔT), with R(0) equal to the resistance at T=0. With many metals, the temperature coefficient ξ(T) - at least at temperatures 0 < T < 200°C - is constant and independent from the temperature. A resistance coefficient independent from the temperature is advantageous as it facilitates the determination of the temperature from the resistance measured value.

An important prerequisite for a linear dependence of the resistance on the temperature or the like, besides the suitable choice of the metal, is the correct choice of the substrate. Ideally, the substrate should have a similar coefficient of thermal expansion (CTE) to that of the sensor metal deposited on it. Especially, if the CTE of the substrate is larger than that of the metal, cracks in the metal layer can occur, and this leads to an undesired drift of the sensor. Aluminium oxide (Al₂O₃) is a particularly suitable substrate for Pt thin-film sensors. The CTE of Al₂O₃ is 6.5-8.9E-6 (1/K) and is therefore similar to the CTE of the platinum with 8.8E-6 (1/K).

However, ceramic bodies as substrates for temperature sensors have the disadvantage of a lack of mechanical stability with a substrate thickness below 500 µm. In particular, the handleability of larger substrates becomes difficult even at the thickness of less than 1000 µm due to the high tendency to break.

U.S. Patent Number 9,209,047 discloses a flexible semiconductor device in which a device layer is arranged on a polymer layer.

However, flat substrates such as polymer films, especially polyimide films, are not suitable for precise thin film temperature sensors because polymer films change in shape or physical property over time. In addition, the CTE of the polyimide film with 20E-6 (1/K) is too high for the platinum. The conventional technique of producing single encapsulated dies and thin substrates has been described only for ICs but not for tiny and flat sensor with high accuracy.

US 2009/008132 A1 refers to a tape carrier package (TCP), whereby the substrate consists only of an insulating film. The materials to be used for the manufacture of the insulating film are polymers, polyimides, etc.

In US 2012/112347 A1 a flexible electronic element is disclosed. This document relates to fully encapsulated flexible electronic devices. In particular, it refers to such elements that are suitable for in vivo implantation.

In Jiang Shui-Dong ET AL: "Microfabrication of thin film temperature sensor for cryogenic measurement" a comparatively precise temperature sensor is described. The intent is to provide a robust sensor for use at extremely low temperatures of 100 K or less for aerospace application or nuclear fusion power application. Therefore, the assembly described should be fully functional even under high magnetic fields. For this purpose, a substrate with a thickness of at least 500 µm is used.

### Disclosure of invention

The object of the invention is to realize a precise and at the same time flexible passive electronic component, flat sensor.

This object is accomplished in accordance with a flexible passive electronic component, namely a sensor, whose substrate is formed from an insulating layer and a further inorganic layer with a total thickness of at most 50 µm, and whose height is at most 150 µm. The high precision and long-term stability of the flexible passive electronic component is ensured by using the inorganic layer. In contrast to polymeric substrates, the inorganic layer shows no temporal change and has a relatively low CTE. In addition, in contrast to ceramic substrates, the inorganic layer or the substrate consisting of the insulating layer and the inorganic layer can be thinned down to a thickness of 50 µm or less, while keeping the mechanical stability. The thinned substrate provides flexibility to the flexible passive electronic component. This flexibility can still be maintained by the limited overall height of the flexible passive electronic component with at most 150 µm. Furthermore, the flexible passive electronic component, namely the sensor, with small mass follows rapidly the surrounding environment, resulting in a quick response in measurements.

The flexible passive electronic component is not an integrated circuit (IC) or does not contain an integrated circuit (IC).

In a preferred embodiment, the substrate has a thickness of at most 35 µm, particularly preferably at most 20 µm. It proves to be especially advantageous because the thinner substrate provides more flexibility while maintaining its stability. The minimum thickness of the inorganic layer together with the insulating layer is exemplified by 10 µm.

In a preferred embodiment, the flexible passive electronic component has a height of at most 70 µm, particularly preferably at most 40 µm. The reduced height of the flexible passive electronic component proves to be advantageous in terms of more flexibility and quicker responsiveness.

In a preferred embodiment, the flexible passive electronic component has a flexibility that is bendable with a radius of bending curvature of at least 5 mm, preferably at least 2 mm, preferably at least 1 mm, wherein a relative difference (d R/RO) of resistivity, wherein d means delta or Δ) of the electrical structure before and after bending may not exceed 0,5%. The flexible passive electronic component with such a flexibility may be suitable for use under a bending stress due to a thermal expansion/shrink or external mechanical stress.

Such a flexibility of the flexible passive electronic component can be measured as follows. The flexible passive electronic component is glued on a Polyimide foil (Kapton^{®}, 25 µm) to determine the flexible passive electronic component's flexibility. Prior to gluing, the surface of the Kapton film is activated by treatment with a corona discharge. A cyano-based glue (MINEA, superglue) is applied on the backside of the thin flexible passive electronic component and the flexible passive electronic component is pressed on Polyimide foil for the reaction time of the glue. The polyimide foil is wrapped around a cylindrical bar with the flexible passive electronic component directed outwards. The diameter of the bar is chosen to be in the range of 0,5 mm to 10 mm. When being wrapped, the polyimide foil is in close contact with the surface of the cylindrical bar. Therefore, the radius of curvature applied to the flexible passive electronic component is approximatively half of the bar's diameter. The duration at which maximal bending is applied is set to approximately one second. The relative difference of (d R/RO) of resistivity (wherein d means delta or Δ) of the electrical structure is measured before and after each bending cycle. The flexible passive electronic component is meant to be flexible as long as the radius of curvature is not smaller than the minimal radius Rm. Rm is defined by the radius at which d R/R(0) = 0,5%.

The inorganic layer is made of an inorganic crystalline material, in particular silicon, silicon carbide, gallium arsenide or sapphire, or is made of an inorganic amorphous material, in particular quartz glass, borosilicate glass or glass, or is made from a silicon-on-insulator (SOI) wafer.

In a preferable embodiment, the flexible passive electronic component has a length, a width and the height, wherein the cross-section (length x width) is at most 4 mm², preferably at most 2 mm², particularly preferably at most 1 mm². Owing to the comparatively small length and width with the limited height, advantageously a low mass and consequently a rapid responsiveness are guaranteed.

In a preferable embodiment, the electrical structure includes at least one conductor track and at least two electrical contact pads, wherein the at least two electrical contact pads are electrically connected to the at least one conductor track. The conductor track may be constructed to extend in the shape of a meander.

In a preferable embodiment, the at least one conductor track has a uniform width, wherein the width is not more than 5 µm and the standard deviation of the width is not more than 5% of the width. The thin and uniform conductor track is advantageous for quick and stable response to the rapidly changing measurement parameters. The conductor track may be formed at least partially as an adjustment straining to allow in-line trimming of the conductor track's overall resistance.

In a preferable embodiment, the conductor track has a temperature coefficient of electrical resistance of at least 3.000 ppm/K, preferably at least 3.500 ppm/K, particularly preferably at least 3.800 ppm/K.

In a preferable embodiment, the flexible passive electronic component may further comprise at least one additional electrical structure. Each additional electrical structure may include at least one conductor track. The electrical structure and the at least one additional electrical structure may be arranged in a multilayer structure such that:
a) the conductor tracks of the electrical structure and the at least one additional electrical structure are arranged one above the other on different planes; and
b) the adjacent conductor tracks lying one above the other are at least partially separated from one another by an additional insulating layer; and
optionally c) the adjacent conductor tracks lying one above the other are electrically connected to one another via one or more conducting vias formed through the additional insulating layer.

The increased sensing area with the multi-layered electrical structure is advantageous for the improved sensing accuracy and performance, while keeping the flexible passive electronic component small.

The insulating layer is made of metal oxides and/or metal nitrides, in particular aluminium oxide, aluminium nitride, hafnium oxide or hafnium nitride. The insulating layer made of such a material exhibits stable electrical insulation on the inorganic layer. The material of the insulating layer, however, is not limited to these, as long as necessary electrical insulation can be obtained on the substrate surface.

In a further preferable embodiment, the flexible passive electronic component may further comprise a cover layer at least partially covering the electrical structure. The cover layer may be formed from an inorganic layer. The electrical structure is thereby protected, particularly in an aggressive environment, so that the long-term stability can be achieved.

In a further preferable embodiment, the flexible passive electronic component may further comprise a first protective layer. The first protective layer at least partially, in particular completely, covers the cover layer. The first protective layer may be made of polymeric material such as polystyrene (PS), polyethylene (PE) and polyimide (PI). Preferably, the material consists of photostructurable polyimide (PS-PI). The material is photostructured according to a mask of the cover layer.

The electrical structure is designed as a sensor element. In a preferable embodiment, the electrical structure is designed as a sensor element and heater element. The sensor may be designed as a temperature sensor, flow sensor, particle sensor or chemical sensor.

In an example of the flow sensor, one heater element may be arranged between two temperature sensor elements in the flow direction.

In an example of the temperature sensor, the electrical structure may have an electrical resistance of at least 100 Ohm, preferably at least 1.000 Ohm, particularly preferably at least 10.000 Ohm. Low self-heating is thereby achieved.

In an example of the electrical structure as the heater element, it may have an electrical resistance of at most 5 Ohm, preferably at most 2 Ohm, preferably at most 1 Ohm. The conductor track of the heater element is preferably designed as a square, a U-loop. Preferable the heater element is designed as multiple parallel addressed conductor tracks, whereinthe conductor tracks have uniform width, the width being not more than 5 µm and the standard deviation of the width being not more than 5% of the width.

In a preferable embodiment, the flexible passive electronic component may further comprise a second protective layer on the lower side of the inorganic layer. The second protective layer may be made of polymeric material such as polystyrene (PS), polyethylene (PE) and polyimide (PI). The protective layer is not limited to these as long as it has appropriate mechanical stability, electrical insulation and heat transfer properties.

The above objective is accomplished according to an inventive flexible passive electronic component system. The flexible passive electronic component system comprises at least one flexible passive electronic component according to any of the above inventive aspects, and at least one electrical control. The electrical control may be electrically connected to the electrical structure. The electrical control is configured to control the flexible passive electronic component.

In an example of a temperature flexible passive electronic component, the electrical control is configured to supply a constant current to the electrical structure (resistance element), to measure the voltage across the electrical structure, calculate the resistance value based on Ohm's law, and derive a temperature corresponding to the resistance value.

The above objective is accomplished according to an inventive method for producing an aforementioned flexible passive electronic component according to the invention. The method comprises following process steps:
a) providing an inorganic wafer having an upper side and a lower side,
b) applying an insulating layer on the upper side of the inorganic wafer,
c) applying and structuring an electrical structure or multilayered electrical structure on the insulating layer,
d) applying a cover layer on the electrical structure,
e) thinning the inorganic wafer on its lower side, particularly by mechanical removal and/or an etching process, to a thickness of a substrate, which comprises the insulating layer and the inorganic wafer, of at most 50 µm, preferably at most 35 µm, particularly preferably at most 20 µm.

In a preferable embodiment, to apply the electrical structure, a metal layer may be first applied to an inorganic wafer such as silicon wafer, silicon-on-insulator (SOI) wafer or glass wafer, which is then photolithographically structured. The metal layer may be made of platinum (Pt), aluminium (Al), nickel (Ni) or alloys such as an aluminium-copper (Al-Cu) alloy with 99,5% Al and 0,5% Cu, or an alloy containing at least Pt, Al and/or Ni.

In a preferable embodiment, the method may further comprise steps of:
f) applying a protective layer on the side of the electrical structure and/or the lower side of the substrate, and optionally
g) removing the first protective layer after the step of thinning the inorganic wafer.

In an embodiment of the invention, it is possible that in step e), the inorganic wafer is completely removed so that the substrate comprises only the insulation layer.

It proves to be especially advantageous in that the electrical structure can be prevented from damage during the thinning process.

### Brief description of drawings

FIG. 1 shows a cross section of a first preferred embodiment of a flexible passive electronic component, in particular a sensor, of the invention;
FIG. 2 shows a plan view of the flexible passive electronic component in accordance with FIG. 1;
FIGS. 3A to 3M show cross sectional views of a technique for manufacturing a flexible passive electronic component in accordance with the invention; and
FIG. 4 shows a cross section of a second preferred embodiment of a flexible passive electronic component of the invention.

### Description of Specific Embodiment

In the following description, a temperature sensor will be mainly described. However, the application of the present invention is not limited to the temperature sensor, and the invention can be advantageously applied to a flow sensor, a chemical (gas) sensor, particle sensor, or the like.

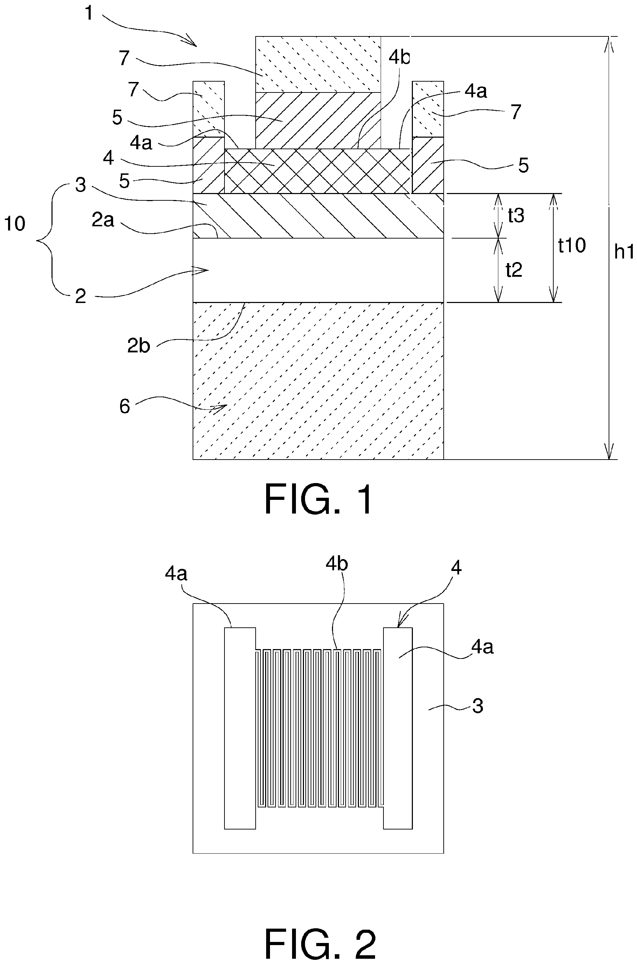

In accordance with FIGS. 1 and 2, the sensor 1 comprises a substrate 10. The substrate 10 comprises an inorganic layer 2 with an upper side 2a and a lower side 2b, an insulating layer 3, and an electrical structure 4. The insulating layer 3 at least partially covers the upper side 2a of the inorganic layer 2. The insulating layer 3 may cover the entire upper side surface of the inorganic layer 2, as depicted. The electrical structure 4 at least partially covers the insulating layer 3.

The substrate 10 has a thickness t10, which is at most 50 µm, preferably at most 35 µm, particularly preferably at most 20 µm. In other words, the thickness t10 of a substrate 10 is made of a thickness t2 of the inorganic layer 2 and a thickness t3 of the insulating layer 3. In the case where the substrate 10 has only an insulating layer 3, the thickness t10 is equivalent to the thickness t3.

The sensor 1 has a height h1, which is at most 150 µm, preferably at most 70 µm, particularly preferably at most 40 µm. The thinned substrate 10 provides flexibility to the sensor 1. This flexibility can still be maintained by the limited overall height h1 of the sensor 1 with at most 150 µm. Furthermore, the sensor 1 with small mass follows rapidly the surrounding environment, resulting in a quick response in measurements.

The inorganic layer 2 may be made of an inorganic crystalline material, in particular silicon, silicon carbide, gallium arsenide or sapphire, or made of an inorganic amorphous material, in particular quartz glass, borosilicate glass or glass, or made from a silicon-on-insulator (SOI) wafer.

The insulating layer 3 may be made of metal oxides and/or metal nitrides, in particular silicon dioxide, silicon nitride, aluminium oxide, aluminium nitride, hafnium oxide or hafnium nitride. The electrical structure 4 may be made of platinum, nickel, aluminium or alloys such as an alloy at least containing platinum, nickel and/or aluminium, or an aluminium-copper (Al-Cu) alloy with 99,5% Al and 0,5% Cu.

The sensor 1 may further comprise a cover layer 5 at least partially covers the electrical structure 4. The cover layer 5 may expose one or more parts of the electrical structure 4 for one or more electrical contact pads 4a. The cover layer 5 may be formed from an inorganic layer. The sensor 1 may further comprise a protective layer 6 on the lower side 2b of the inorganic substrate 10. The protective layer 6 may be made of polymeric material such as polystyrene (PS), polyethylene (PE) or polyimide (PI). The protective layer 6 is not limited to these as long as it has appropriate electrical insulation and heat transfer properties.

The specific shape of the electrical structure 4 can be seen from FIG. 2. For example, the two electrical contact pads 4a discussed above extend in parallel and spaced from each other. The total area of the electrical contact pads 4a and the conductor track 4b may be half of the area of the substrate 10. For example, when the area of the substrate 10 is 1 × 1 mm², each area of the electrical contact pad 4a is 0,1 mm². This is an example, and the dimensions of sensor 1 and contact pad 4a are not limited to these. The electrical structure 4 may include more than two electrical contact pads 4a in the same plane.

Besides the contact pads 4a, the electrical structure 4 includes at least one conductor track 4b. The conductor track 4b is electrically connected to both of the electrical contact pads 4a. The conductor track 4b has a first end and second end. The first end of the conductor track 4b is connected to one contact pad 4a; the second end of the conductor track 4b is connected to the other contact pad 4a.

In the illustrated example, the conductor track has a meander shape that repeatedly bends in S-shape. The shape of the conductor track 4b is not limited to this as long as a necessary conductor length or resistance value is obtained. Preferably, the conductor track 4b has a uniform width, wherein the width is not more than 5 µm and the standard deviation of the width is not more than 5% of the width. The thin and uniform conductor track 4b is advantageous for quick and stable response to the rapidly changing measurement parameters. The conductor track 4b may be formed at least partially as an adjustment straining.

The conductor track 4b may be applied as a sensor element and/or heater element. In an application to a chemical sensor, a catalytic material may be provided on the conductor track 4b as a sensor element. Also, another conductor track (not shown) as a heater element may be placed adjacent to above or below the conductor track 4b as the sensor element. In an application to a flow sensor, one conductor track as a heater element may be arranged between two conductor tracks as sensor elements.

In an example of the temperature sensor, the electrical structure 4 may have an electrical resistance of at least 100 Ohm, preferably at least 1.000 Ohm, particularly preferably at least 10.000 Ohm. Low self-heating is thereby achieved.

In an example of the electrical structure 4 as the heater element, it may have an electrical resistance of at most 5 Ohm, preferably at most 2 Ohm, preferably at most 1 Ohm. The conductor track of the heater element is preferably designed as a square or a U-loop. Preferable the heater element is designed as multiple parallel addressed conductor tracks, whereinthe conductor tracks have uniform width, the width being not more than 5 µm and the standard deviation of the width being not more than 5% of the width.

Although not shown, the sensor 1 may further comprises at least one additional electrical structure. Each additional electrical structure may include at least one conductor track which has the same structure as the conductor track 4b described above. The electrical structure 4 and the at least one additional electrical structure may be arranged in a multilayer structure such that:
a) the conductor tracks 4b of the electrical structure 4 and the at least one additional electrical structure are arranged one above the other on different planes; and
b) the adjacent conductor tracks 4b lying one above the other are at least partially separated from one another by an additional insulating layer; and optionally
c) the adjacent conductor tracks 4b lying one above the other are electrically connected to one another via one or more conducting vias formed through the additional insulating layer.

The increased sensing area with the multi-layered electrical structures 4 is advantageous for the improved sensing accuracy or performance, while keeping the sensor 1 small. The additional insulating layer may have the same configuration as the insulating layer 3 on the inorganic layer 2.

Design example of the sensor for the temperature sensor may be as follows:
With sensor area 1 × 1 mm² (1mm in length and 1 mm in width), half of the substrate is coved by the contact pads 4a and the conductor track 4b, whereby the area of the contact pads 4a is at least 2 × 0,15 mm² and the conductor track is formed as meander. The width of conductor track (line) of platinum is 1 µm; the spacing between the adjacent metal lines is 1,5 µm. The number of parallel metal lines is 200 with a total length of 20 cm. The electric resistivity of platinum (ρ_{Pt}) is 1,06 µOhm m. The electric resistance R of the conductor track is obtained by R = ρ_{Pt} x L / (B × H)

| L: length (cm) | B: width (µm) | H: height (µm) | Line resistance (kOhm) |
|---|---|---|---|
| 20 | 1 | 1 | 212 |
| 10 | 1,5 | 0,5 | 141 |

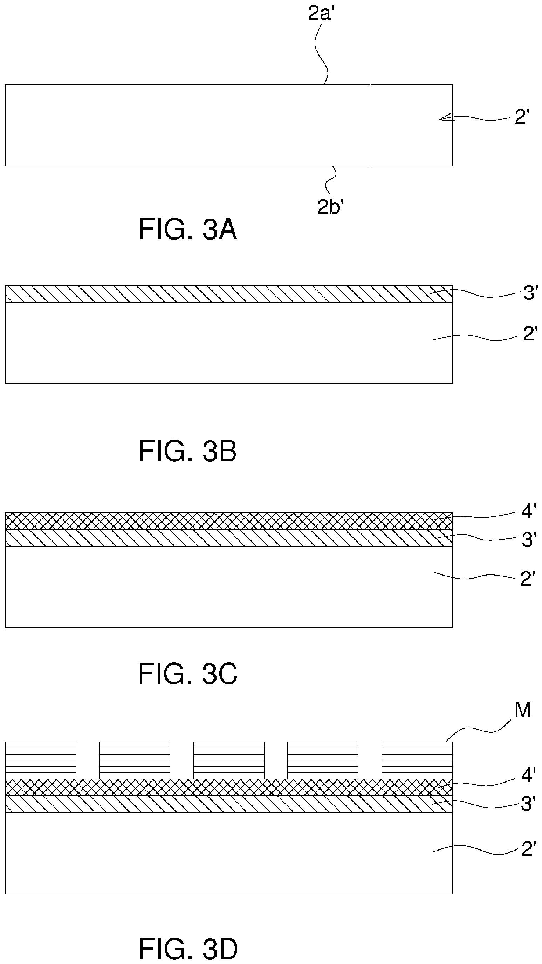

With reference to FIGS. 3A to 3M, an embodiment of a method of producing the sensor 1 shown in FIGS. 1 and 2 will be described.

FIG. 3A shows an inorganic wafer or plate 2' having an upper side 2a' and a lower side 2b' . The inorganic wafer 2' may be made of an inorganic crystalline material, in particular silicon, silicon carbide, gallium arsenide or sapphire, or may be made of an inorganic amorphous material, in particular quartz glass, borosilicate glass or glass, or preferably a silicon-on-insulator (SOI) wafer. The wafer 2' is thinned in a later process. The initial wafer thickness until then is preferably about 0,5 mm to 1 mm for the purpose of easy handling.

FIG. 3B shows that an insulating layer 3' is applied on the upper side 2a' of the inorganic wafer 2'. The insulating layer 3' may be an electrically insulating oxide layer. To this end, a silicon wafer as the inorganic wafer 2' is oxidized. A SOI wafer may be used from the beginning. Alternatively, an electrically insulating oxide layer can be deposited.

FIG.3C shows that a metal layer 4' is applied on the electrically insulating layer 3'. The metal layer 4' may be evaporated or sputtered onto the insulating layer 3'. The metal layer 4' may be made of platinum (Pt), aluminium (Al), nickel (Ni) or alloys such as an aluminium-copper (Al-Cu) alloy with 99,5 % Al and 0,5 % Cu or alloy containing at least Pt, Al and/or Ni.

FIG. 3D shows that a mask M is applied on the metal layer 4'. To this end, a photoresist is applied on the metal layer 4' and is exposed and developed to the predetermined pattern.

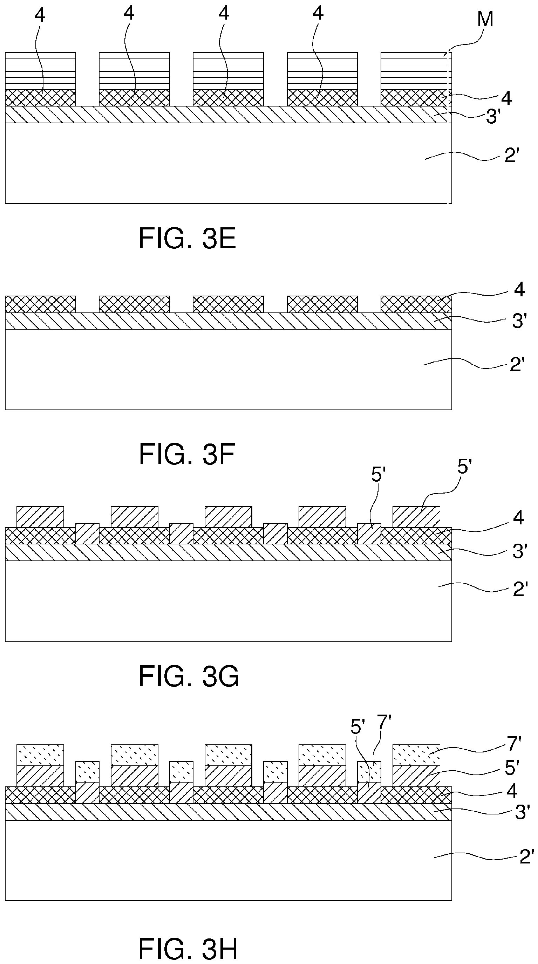

FIG. 3E shows that a plurality of electrical structures 4 each including at least two electrically contact pads 4a and at least one conductor track 4b are structured from the metal layer 4'. The metal layer 4' is etched by wet chemical etching or dry etching, leaving parts covered with the mask M.

FIG. 3F shows that the mask M is removed by, for instance, stripping.

FIG. 3G shows that a cover layer 5 is applied on parts of the electrical structure 4, leaving parts that become the electrical contact pads 4a free. To this end, an inorganic material such as silicon dioxide (SiO₂) and optionally silicon nitride (Si₃N₄) is applied and structured by dry etching and/or wet etching, leaving parts covered with an additional mask (not shown). After applying the cover layer 5, the mask is removed by, for example, lift-off.

FIG. 3H shows that a first protective layer 7 is applied on the side of the electrical structure 4, covering the electrical structure 4, the cover layer 5, and parts of the insulating layer 3 exposed from the electrical structure 4. The first protective layer 7 may be a polymer layer made of polystyrene (PS), polyethylene (PE), polyimide (PI), or the like. Preferably, the organic material consists of photostructurable polyimide (PS-PI). The material is photostructured according to the mask of the cover layer 5.

Optionally, the electrical contact pads 4a are passivated with galvanic precious metal layers (not shown) applied thereon. An electroplating such as electroless nickel immersion gold (ENIG) may be applied on the electrical contact pads 4a.

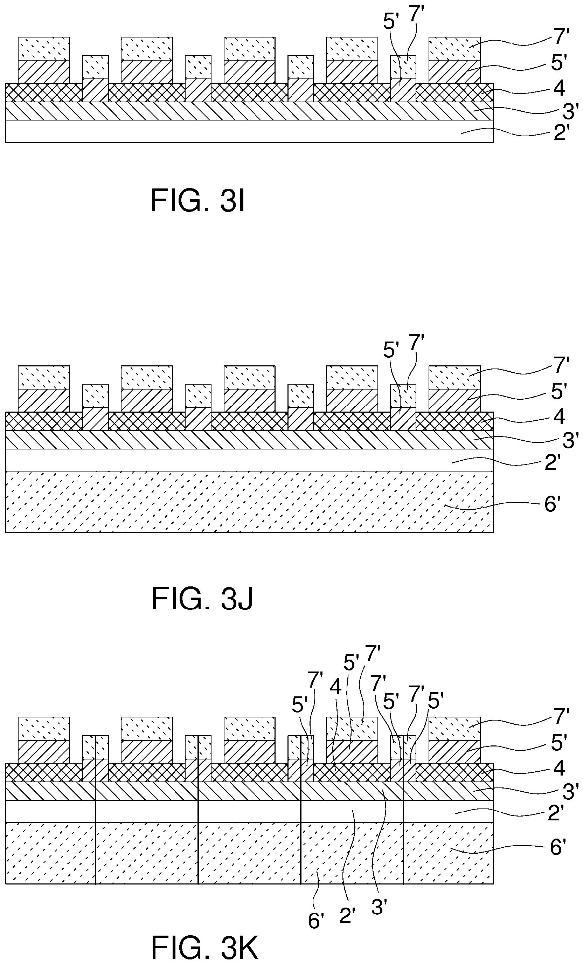

FIG. 3I shows that the inorganic wafer 2' together with the insulation layer 3' is thinned down to at most 50 µm, preferably at most 35 µm, particularly preferably at most 20 µm, by various processes such as grinding, chemomechanical polishing (CMP), etching, or combination thereof, or the like. It proves to be advantageous that damage and/or contaminations of removed wastes to the electrical structure 4, cover layer 5 and insulating layer 3' can be effectively prevented under the protection by the first protective layer 7. Besides, the inorganic wafer 2' can be thinned in a stable state with the help of reinforcement by the first protective layer 7.

FIG. 3J shows that a second protective layer 6' that to be the protective layer 6 is applied on the thinned surface (lower side) of the inorganic wafer 2'. The second protective layer 6' may be a polymer layer made of polystyrene (PS), polyethylene (PE), polyimide (PI), or the like.

FIG. 3K shows that the inorganic wafer 2' is diced together with the insulating layer 3', the first protective layer 7', the second protective layer 6' and the cover layer 5' into the individual sensors 1 shown in FIG. 1. These cuts are performed by saw, laser, or the like. These sensors 1 may be further processed in any electronic process compatible with SMT. The production of the sensor 1 is completed.

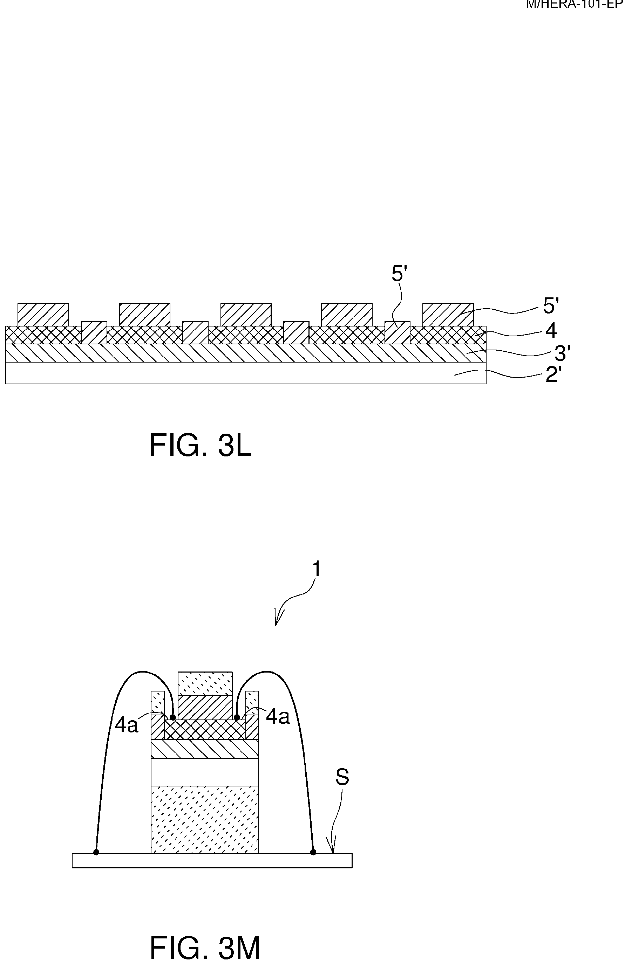

FIG. 3L shows that the first protective layer 7' and the second protective layer 6' are removed. The cover layer 5, the parts of the electrical structure 4 and the inorganic wafer 2' are exposed again. The two protective layers 6' and 7' can, for example, be burnt off.

FIG. 3M shows an example of sensor connection. The sensor 1 may be mounted on the mount board S with the protective layer 6 facing the mount board S. In an application to a temperature sensor, the sensor 1 may be firmly connected to a surface to be measured. The electrical contact pads 4a of the sensor 1 and the mount board S may be electrically connected by wires.

Further advantages of the invented sensors can be found as follows:
- fast response time owing to the low mass, particularly of less than 1 mm² in cross-section x 100 µm in height,
- high mechanical flexibility of the sensor owing to the thinned inorganic substrate,
- low self-heating when the electrical resistance of the conductor track of 100 Ohm to 10.000 Ohm,
- low manufacturing costs (approximately 10.000 sensors may be produced from 100 mm x 100 mm inorganic wafer),
- established lithography processes can be used.

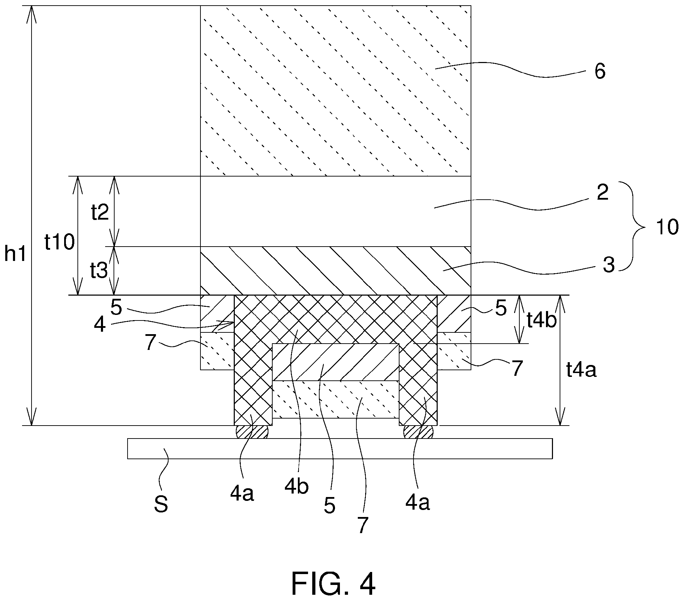

FIG. 4 shows a further preferred embodiment of the invention in which the electrical contact pads 4a are directly connected to electrical lines of a circuit board (not shown). The thickness t4a of the electrical contact pads 4a is larger than the thickness t4b of the conductor track 4b of the electrical structure 4. This structure is achieved by once structuring the conductor track 4b and the electrical contact pads 4a with the same thickness and then selectively etchinga portion corresponding to the conductor track 4b. Alternatively, this can be achieved by once structuring the conductor track 4b and the electrical contact pads 4a with the same thickness and then selectively thickening a portion corresponding to the electrical contact pads 4a by further vapor deposition or plating. The advantage of this design is the further reduction of thermal contact area between the thermal sensor and the circuit board to increase the sensitivity of the electrical structure designed as a thermal sensor, especially in the detection of radiant heat. In a preferred embodiment, the electrical connectivity is ensured by the use of isotropically conductive adhesives (ICA) and/or anisotropically conductive adhesives (ACA) which additionally improve mechanical stability.

### Execution examples:

### Execution example 1: Design of a flexible passive electronic component, in particular a flexible sensor, according to the invention

A 200 mm silicon wafer with a silicon oxide layer on one side and a layer thickness of 1,2 µm is used as the inorganic wafer for the flexible sensor according to the invention. A metal layer is deposited on the silicon oxide layer. The metal layer has a total thickness of 850 nm and consists of an Al-Cu alloy of 99,5% Al and 0,5% Cu. The metal layer is then lithographically divided into individual electrical structures optional isolated from each other. The electrical structures each consist of a conductor track and two contact pads at the two ends of the conductor track. Each line of the conductor track has a homogeneous width and is arranged in a meander shape between the two contact pads. The electrical structures, which are differently designed on the wafer, are defined in particular by the following parameters:
a) Length of the conductor track (L),
b) Width of the conductor track (W),

The layout for structuring the metal layer is chosen so that the silicon wafer is divided into square fields, with the field area corresponding to 400 mm² each. Each of the fields has the same pattern, consisting of 222 individual electrical structures arranged in individual rows. The electrical structures are divided into different groups, whereby the electrical structures within a group are identical. The electrical structures in at least one of the parameters L, or W differ between the groups.

After structuring the metal layer, the entire surface of the metal layer is first coated with an inorganic cover layer consisting of oxide and nitride layers. The total thickness of the inorganic cover layer is 1,4 µm. To ensure later electrical addressing, this cover layer is opened at the contact pads.

Subsequently, the surface is coated with photostructurable polyimide (PS-PI) with a dry layer thickness of approximately 3 µm and photostructured according to the mask of the cover layer. The surfaces of the contact pads remain free from the inorganic cover layer and the polyimide layer. The uncoated contact pads are then electroplated with a nickel/gold layer approximately 12 µm thick (ENIG process).

### Execution example 2: Electrical characterization of the flexible sensor according to the invention from execution example 1

The individual structures are characterized electrically one after the other. The two contact pads of an electrical structure are contacted with the two double contact tips of a wafer tester. By applying a voltage to the contact tips, R0, i.e. the electrical resistance of the electrical structure at a temperature of 0°C, is determined. The temperature coefficient of resistance (TCR) is determined by determining the resistance R at a second temperature.

Table 1 shows the mean values and the standard deviation of the electrical resistance R0 and the temperature coefficient TCR of the electrical structures of group Z1. For this purpose, individual fields distributed on the wafer are evaluated. Field 51 is located in the center of the wafer, fields 1 and 5 at its lower edge and fields 79 and 83 at its upper edge. 8 structures of group Z1 are evaluated on each field. The structures of group Z1 have a line width W = 6,5 µm.

**Table 1:**

| Field | MEAN R0 | STDEV R0 | MEAN TCR | STDEV TCR |
|---|---|---|---|---|
| # | Ohm | Ohm | ppm/K | ppm/K |
| 1 | 249,1 | 1,8 | 4135,3 | 2,5 |
| 5 | 245,4 | 1,2 | 4139,1 | 1,5 |
| 51 | 249,1 | 0,1 | 4139,0 | 0,3 |
| 79 | 246,9 | 1,5 | 4136,8 | 1,9 |
| 83 | 245,7 | 0,9 | 4139,4 | 0,6 |
| | | | | |
| MEAN | 247,2 | 2,1 | 4137,9 | 2,4 |

As can be seen from Table 1, the mean value of the resistance R0 of structure Z1 is 247,2 Ohm with a standard deviation of 2,1 Ohm relative to the five fields examined. Thus, the relative standard deviation of the resistance R0 is 0,85%. The mean value of the TCR is 4137,9 ppm/ K with a standard deviation of 2,4 ppm/ K. Thus, the relative standard deviation of the TCR is 0,058%.

In Table 2, the electrical resistances of the electrical structures from group Z18 are statistically evaluated. The electrical structures have a line width W = 0,5 µm. There are 18 adjacent electrical structures on each field in the lowest row. Their electrical resistances are shown in Table 2 for one field each from the center, top and bottom of the wafer. The electrical resistance R of the electrical structures was determined at room temperature.

**Table 2:**

| | Top | Center | Bottom | | |
|---|---|---|---|---|---|
| | R (Ohm) | R (Ohm) | R (Ohm) | | |
| 1 | 9305,5 | 9514,3 | 9540,4 | | |
| 2 | 9273,5 | 9496,9 | 9517,5 | | |
| 3 | 9237,7 | 9517,3 | 9474 | | |
| 4 | 9202,7 | 9452,5 | 9431,5 | | |
| 5 | 9201,1 | 9441,7 | 9428,5 | | |
| 6 | 9183,5 | 9344,7 | 9386,4 | | |
| 7 | 9153,3 | 9189 | 9360,7 | | |
| 8 | 9129,7 | 9148,5 | 9328,1 | | |
| 9 | 9129,4 | 9163,9 | 9336,9 | | |
| 10 | 9102,4 | 9152,5 | 9298,5 | | |
| 11 | 9096,5 | 9118,6 | 9298,5 | | |
| 12 | 9105,1 | 9171,4 | 9295,4 | | |
| 13 | 9114,4 | 9152,1 | 9313,8 | | |
| 14 | 9129,3 | 9227,4 | 9335,3 | | |
| 15 | 9142,3 | 9223,1 | 9365,7 | | |
| 16 | 9175,4 | 9275,8 | 9396,7 | | |
| 17 | 9215,3 | 9329,2 | 9436,1 | | |
| 18 | 9241,7 | 9365,3 | 9453,5 | | |
| | | | | | All |
| MEAN | 9174,4 | 9293,6 | 9388,8 | | 9285,6 |
| STDEV | 62,3 | 141,5 | 75,9 | | 131,7 |
| | 0,7% | 1,5% | 0,8% | | 1,4% |

As Table 2 shows, the mean value of resistance R of structure Z2 is 9285,6 Ohm with a standard deviation of 131,7 Ohm relative to the three fields studied. Thus, the relative standard deviation of the resistance R is 1,4%.

Table 3 shows the mean values and standard deviations of the TCRs of the electrical structures of different groups from field 51.

**Table 3:**

| Group | Line width W | MEAN TCR | STDEV TCR |
|---|---|---|---|
| | µm | ppm/K | ppm/K |
| Z18 | 0,5 | 3963 | 3 |
| Z4 | 1 | 4057 | 1 |
| Z8 | 1,3 | 4092 | 1 |
| Z6 | 1,73 | 4107 | 1 |
| Z2 | 2,6 | 4110 | 1 |
| Z1 | 6,5 | 4140 | 1 |

As Table 3 shows, the TCR and the standard deviation of the TCR are largely independent from the width of the conductor track, at least for the conductor track width in the range 0,5 µm to 6,5 µm, although a slight but systematic increase of the mean TCR with broader line width is obvious.

### Execution example 3: Completion of the sensor according to invention from execution example 1

The backside of the silicon wafer from the design example 1 is chemomechanically thinned to a wafer plus insulator thickness of approximately 10 µm. A protection layer of polyimide of approximately 13 µm is then applied to the thinned reverse side.

The electrical structures are then separated with a laser or by dicing. The individual structures are mechanically flexible and can be bent around a round bar with a radius of less than 1 mm. Repeated bending back and forth around the round bar does not significantly alter the R0 value and the TCR value of the electrical structure.

### Execution example 4: Using the flexible sensor according to the invention to measure a temperature

To determine the surface temperature of a test piece, the electrical structure from design example 3 is attached to the surface of the test piece and the two contact pads are connected via leads to a resistance measuring device. By determining the electrical resistance of the electrical structure and using a calibration curve, the surface temperature of the specimen can be deduced.

### Execution example 5:

Sensors according to Execution example 3 with the difference that the silicon oxide layer on one side has a layer thickness of 20 µm. The backside of the silicon wafer is chemomechanically thinned until nothing is left. A protection layer of polyimide of approximately 15 µm is then applied to the thinned reverse side.

This sensor has a similar flexibility as the sensor according to Execution example 3.

### Execution example 6:

In a further example the contact pads are both raised above the conductor track of the electronic structure. The advantage of this design is to reduce the thermal contact area between the sensor and its mount. The sensor structure is free-floating and the thermal leakage is reduced. The free-floating arrangement of the temperature sensor is realized by connecting the raised contact pads directly to electrical lines of a circuit board.

### Execution example 7:

Sensors according to Execution example 3 with R0=9.285 Ohm are glued on a 25 µm Polyimide foil and wrapped around various cylindrical bars with different diameters and d R/RO is measured. The inorganic layer-thickness in total is 20 µm (thinned silicon inorganic layer: 10 µm; thickness of the inorganic isolating layer and protective layer: 10 µm). The results are outlined in Table 4.

**Table 4:**

| Bar diameter / mm | Radius of curvature / mm | d R/RO / % |
|---|---|---|
| 10 | 5 | 0,0 |
| 8 | 4 | 0,0 |
| 6 | 3 | 0,00 |
| 4 | 2 | 0,05 |
| 3 | 1,5 | 0,15 |
| 2 | 1 | 0,5 |
| 1,5 | 0,75 | 1 |
| 1 | 0,5 | Break of sensor |

According to Table 4, the sensors are flexible if the radius of curvature does is not smaller than 1 mm, by means Rm < 1mm.

### List of reference signs

- 1: passive electronic component
- 2: inorganic layer
- 2': inorganic wafer
- 2a: upper side
- 2b: lower side
- 2a': upper side of the wafer
- 2b': lower side of the wafer
- 3, 3': insulating layer
- 4, 4': electrical structure
- 4a: electrical contact pad
- 4b: conductor track
- 5, 5': cover layer
- 6, 6': second protective layer
- 7, 7': first protective layer
- 10: substrate
- S: mount board
- t2: thickness of the inorganic layer
- t3: thickness of the insulating layer
- t10: thickness of the substrate
- t4a: thickness of an electrical contact pad
- t4b: thickness of a conductor track

## Claims

1. A flexible passive electronic component, that is a sensor (1), comprising
- a substrate (10), which comprises an insulating layer (3) and
an inorganic layer (2) with an upper side (2a) and a lower side (2b), whereby the insulating layer (3) at least partially covering the upper side (2a) of the inorganic layer (2),
and
- an electrical structure (4), the electrical structure (4) at least partially covering the insulating layer (3),
whereby
the insulating layer (3) is made of metal oxides and/or metal nitrides
and
the inorganic layer (2) is made of an inorganic crystalline material or an inorganic amorphous material or from a silicon-on-insulator (SOI) wafer, whereby the flexible passive electronic component is not an integrated circuit (IC) or does not contain an integrated circuit (IC), whereby
the electrical structure (4) is designed as a sensor element,
**characterized in that**
the substrate (10) has a thickness (t10) which is at most 50 µm and the flexible passive electronic component (1) has a height (h1) which is at most 150 µm.

2. The flexible passive electronic component (1) according to claim 1, wherein
the flexible passive electronic component (1) has a flexibility that is bendable with a radius of bending curvature of at least 5 mm, preferably at least 2 mm, particularly preferably at least 1 mm, and
wherein a relative difference (d R/RO) of resistivity of the electrical structure (4) before and after bending may not exceed 0,5%.

3. The flexible passive electronic component (1) according to claim 1 or 2, wherein
the inorganic layer (2) is made of silicon or silicon carbide or gallium arsenide or sapphire or quartz glass or borosilicate glass or glass.

4. The flexible passive electronic component (1) according to any one of claims 1 to 3,
wherein
the flexible passive electronic component(1) has a length, a width and the height (h1), wherein the product of the length times the width is at most 4 mm², preferably at most 2 mm², particularly preferably at most 1 mm².

5. The flexible passive electronic component (1) according to any one of claims 1 to 4,
wherein
the electrical structure (4) includes at least one conductor track (4b) and at least two electrical contact pads (4a), the at least two electrical contact pads (4a) being electrically connected to the at least one conductor track (4b),
preferably wherein the at least one conductor track (4b) has a uniform width, the width being not more than 5 µm and the standard deviation of the width being not more than 5% of the width.

6. The flexible passive electronic component (1) according to claim 5, wherein
the conductor track (4b) has a temperature coefficient of electrical resistance of at least 3.000 ppm/K, preferably at least 3.500 ppm/ K, particularly preferably at least 3.800 ppm/ K.

7. The flexible passive electronic component (1) according to any one of claims 1 to 6, further comprising at least one additional electrical structure, each including at least one conductor track,
wherein the electrical structure (4) and the at least one additional electrical structure are arranged in a multilayer structure such that:
a) the conductor tracks (4b) of the electrical structure (4) and the at least one additional electrical structure are arranged one above the other on different planes; and
b) the adjacent conductor tracks (4b) lying one above the other are at least partially separated from one another by an additional insulating layer;
optionally
c) the adjacent conductor tracks (4b) lying one above the other are electrically connected to one another via one or more conducting vias formed through the additional insulating layer.

8. The flexible passive electronic component (1) according to any one of claims 1 to 7,
wherein
the insulating layer (3) is made of aluminium oxide, aluminium nitride, hafnium oxide or hafnium nitride.

9. The flexible passive electronic component (1) according to any one of claims 1 to 8,
wherein
the electrical structure (4) is made of platinum, nickel, aluminium or an alloy containing platinum, nickel and/or aluminium.

10. The flexible passive electronic component (1) according to any one of claims 1 to 9, further comprising a cover layer (5) at least partially covering the electrical structure (4), the cover layer (5) being formed from an inorganic layer.

11. The flexible passive electronic component (1) according to any one of claims 1 to 10,
wherein
the electrical structure (4) is designed as a heater element.

12. The flexible passive electronic component (1) according to any one of claims 1 to 11,
wherein
the electrical structure (4) as the sensor element has an electrical resistance of at least 100 Ohm, preferably at least 1000 Ohm, preferably at least 10000 Ohm, or
wherein the electrical structure (4) as the heater element has an electrical resistance of at most 5 Ohm, preferably at most 2 Ohm, preferably at most 1 Ohm.

13. A flexible passive electronic component system, comprising at least one flexible passive electronic component (1) according to any one of claims 1 to 12, and at least one electrical control, the electrical control being electrically connected to the electrical structure (4) and configured to control the flexible passive electronic component (1).

14. A method for producing a flexible passive electronic component (1) according to any one of Claims 1 to 12, comprising following process steps:
a) providing an inorganic wafer (2') having an upper side (2a') and a lower side (2b'),
b) applying an insulating layer (3') on the upper side (2a') of the inorganic wafer (2'),
c) applying and structuring an electrical structure (4') or multilayered electrical structures on the insulating layer (3'),
d) applying a cover layer (5') on the electrical structure (4'),
e) thinning the inorganic wafer (2') on the lower side (2b'), to a thickness (t10) of a substrate (10), comprising the insulating layer (3) and optionally the inorganic wafer (2'), of at most 50 µm, preferably at most 35 µm, particularly preferably at most 20 µm.

15. The method according to claim 14 further comprising steps of:
f) applying a first protective layer (7) on the side of the electrical structure (4') and/or the lower side (2b) of the substrate (10), and optionally
g) removing the first protective layer (7) after the step of thinning the inorganic wafer (2').

## Patentansprüche

1. Flexible passive elektronische Komponente, bei der es sich um einen Sensor (1) handelt, umfassend:
- ein Substrat (10), das eine Isolierschicht (3) und eine anorganische Schicht (2) mit einer Oberseite (2a) und einer Unterseite (2b) umfasst, wobei die Isolierschicht (3) wenigstens teilweise die Oberseite (2a) der anorganischen Schicht (2) bedeckt,
und
- eine elektrische Struktur (4), wobei die elektrische Struktur (4) wenigstens teilweise die Isolierschicht (3) bedeckt,
wobei
die Isolierschicht (3) aus Metalloxiden und/oder Metallnitriden hergestellt ist
und
die anorganische Schicht (2) aus einem anorganischen kristallinen Material oder einem anorganischen amorphen Material oder aus einem Silicon-on-Insulator-Wafer (SOI-Wafer) hergestellt ist, wobei
die flexible passive elektronische Komponente keine integrierte Schaltung (*integrated circuit* - IC) ist oder keine integrierte Schaltung (IC) enthält, wobei die elektrische Struktur (4) als Sensorelement ausgeführt ist,
**dadurch gekennzeichnet, dass**
das Substrat (10) eine Dicke (t10) aufweist, die höchstens 50 µm beträgt, und die flexible passive elektronische Komponente (1) eine Höhe (h1) aufweist, die höchstens 150 µm beträgt.

2. Flexible passive elektronische Komponente (1) nach Anspruch 1, wobei
die flexible passive elektronische Komponente (1) eine Flexibilität aufweist, die mit einem Biege-/Krümmungsradius von wenigstens 5 mm, vorzugsweise wenigstens 2 mm, besonders bevorzugt wenigstens 1 mm, biegbar ist, und
wobei ein relativer Unterschied (d R/RO) des spezifischen Widerstands der elektrischen Struktur (4) vor und nach dem Biegen 0,5 % nicht übersteigen darf.

3. Flexible passive elektronische Komponente (1) nach Anspruch 1 oder 2, wobei
die anorganische Schicht (2) aus Silizium oder Siliziumcarbid oder Galliumarsenid oder Saphir oder Quarzglas oder Borosilikatglas oder Glas hergestellt ist.

4. Flexible passive elektronische Komponente (1) nach einem der Ansprüche 1 bis 3, wobei
die flexible passive elektronische Komponente (1) eine Länge, eine Breite und die Höhe (h1) aufweist, wobei das Produkt der Länge mal der Breite höchstens 4 mm², vorzugsweise höchstens 2 mm², besonders bevorzugt höchstens 1 mm², beträgt.

5. Flexible passive elektronische Komponente (1) nach einem der Ansprüche 1 bis 4, wobei
die elektrische Struktur (4) wenigstens eine Leiterbahn (4b) und wenigstens zwei elektrische Kontaktpads (4a) umfasst, wobei die wenigstens zwei elektrischen Kontaktpads (4a) elektrisch mit der wenigstens einen Leiterbahn (4b) verbunden sind,
wobei vorzugsweise die wenigstens eine Leiterbahn (4b) eine einheitliche Breite aufweist, wobei die Breite nicht mehr als 5 µm beträgt und die Standardabweichung der Breite nicht mehr als 5 % der Breite beträgt.

6. Flexible passive elektronische Komponente (1) nach Anspruch 5, wobei
die Leiterbahn (4b) einen Temperaturkoeffizienten des elektrischen Widerstands von wenigstens 3.000 ppm/K, vorzugsweise wenigstens 3.500 ppm/K, besonders bevorzugt wenigstens 3.800 ppm/K, aufweist.

7. Flexible passive elektronische Komponente (1) nach einem der Ansprüche 1 bis 6, die ferner wenigstens eine zusätzliche elektrische Struktur umfasst, die jeweils wenigstens eine Leiterbahn umfasst,
wobei die elektrische Struktur (4) und die wenigstens eine zusätzliche elektrische Struktur in einer Mehrschichtstruktur angeordnet sind, sodass:
a) die Leiterbahnen (4b) der elektrischen Struktur (4) und der wenigstens einen zusätzlichen elektrischen Struktur übereinander auf verschiedenen Ebenen angeordnet sind; und
b) die benachbarten Leiterbahnen (4b), die übereinander liegen, durch eine zusätzliche Isolierschicht wenigstens teilweise voneinander getrennt sind; optional
c) die benachbarten Leiterbahnen (4b), die übereinander liegen, über eine oder mehrere leitende Durchkontaktierungen, die durch die zusätzliche Isolierschicht hindurch ausgebildet sind, elektrisch miteinander verbunden sind.

8. Flexible passive elektronische Komponente (1) nach einem der Ansprüche 1 bis 7, wobei
die Isolierschicht (3) aus Aluminiumoxid, Aluminiumnitrid, Hafniumoxid oder Hafniumnitrid hergestellt ist.

9. Flexible passive elektronische Komponente (1) nach einem der Ansprüche 1 bis 8, wobei
die elektrische Struktur (4) aus Platin, Nickel, Aluminium oder einer Legierung, die Platin, Nickel und/oder Aluminium enthält, hergestellt ist.

10. Flexible passive elektronische Komponente (1) nach einem der Ansprüche 1 bis 9, die ferner eine Deckschicht (5) umfasst, welche die elektrische Struktur (4) wenigstens teilweise bedeckt, wobei die Deckschicht (5) aus einer anorganischen Schicht ausgebildet ist.

11. Flexible passive elektronische Komponente (1) nach einem der Ansprüche 1 bis 10, wobei
die elektrische Struktur (4) als Heizelement ausgeführt ist.

12. Flexible passive elektronische Komponente (1) nach einem der Ansprüche 1 bis 11, wobei
die elektrische Struktur (4) als das Sensorelement einen elektrischen Widerstand von wenigstens 100 Ohm, vorzugsweise wenigstens 1000 Ohm, vorzugsweise wenigstens 10000 Ohm, aufweist oder
wobei die elektrische Struktur (4) als das Heizelement einen elektrischen Widerstand von höchstens 5 Ohm, vorzugsweise höchstens 2 Ohm, vorzugsweise höchstens 1 Ohm, aufweist.

13. Flexibles passives elektronisches Komponentensystem, das wenigstens eine flexible passive elektronische Komponente (1) nach einem der Ansprüche 1 bis 12 und wenigstens eine elektrische Steuerung umfasst, wobei die elektrische Steuerung elektrisch mit der elektrischen Struktur (4) verbunden und dazu ausgestaltet ist, die flexible passive elektronische Komponente (1) zu steuern.

14. Verfahren zur Herstellung einer flexiblen passiven elektronischen Komponente (1) nach einem der Ansprüche 1 bis 12, das folgende Verfahrensschritte umfasst:
a) Bereitstellen eines anorganischen Wafers (2') mit einer Oberseite (2a') und einer Unterseite (2b'),
b) Aufbringen einer Isolierschicht (3') auf die Oberseite (2a') des anorganischen Wafers (2'),
c) Aufbringen und Strukturieren einer elektrischen Struktur (4') oder mehrschichtiger elektrischer Strukturen auf die/der Isolierschicht (3'),
d) Aufbringen einer Deckschicht (5') auf die elektrische Struktur (4'),
e) Dünnen des anorganischen Wafers (2') auf der Unterseite (2b') auf eine Dicke (t10) eines Substrats (10), das die Isolierschicht (3) und optional den anorganischen Wafer (2') umfasst, von höchstens 50 um, vorzugsweise höchstens 35 um, besonders bevorzugt höchstens 20 um.

15. Verfahren nach Anspruch 14, das ferner folgende Schritte umfasst:
f) Aufbringen einer ersten Schutzschicht (7) auf die Seite der elektrischen Struktur (4') und/oder die Unterseite (2b) des Substrats (10) und optional
g) Entfernen der ersten Schutzschicht (7) nach dem Schritt des Dünnens des anorganischen Wafers (2').

## Revendications

1. Composant électronique passif flexible, c'est-à-dire un capteur (1), comprenant
- un substrat (10), qui comprend une couche isolante (3) et une couche inorganique (2) avec une face supérieure (2a) et une face inférieure (2b), de sorte que la couche isolante (3) recouvre au moins partiellement la face supérieure (2a) de la couche inorganique (2),
et
- une structure électrique (4), la structure électrique (4) recouvrant au moins partiellement la couche isolante (3),
de sorte que la couche isolante (3) est constituée d'oxydes métalliques et/ou de nitrures métalliques et
la couche inorganique (2) est constituée d'un matériau cristallin inorganique ou d'un matériau amorphe inorganique ou d'une plaquette de silicium sur isolant (SOI), de sorte que le composant électronique passif flexible n'est pas un circuit intégré (CI) ou ne contient pas de circuit intégré (CI), de sorte que la structure électrique (4) est conçue comme un élément de capteur,
**caractérisé en ce que** le substrat (10) a une épaisseur (t10) qui est au maximum de 50 µm et le composant électronique passif flexible (1) a une hauteur (h1) qui est au maximum de 150 µm.

2. Composant électronique passif flexible (1) selon la revendication 1, dans lequel le composant électronique passif flexible (1) a une flexibilité qui est pliable avec un rayon de courbure de flexion d'au moins 5 mm, de préférence d'au moins 2 mm, de manière particulièrement préférée d'au moins 1 mm, et
dans lequel une différence relative (d R/RO) de résistivité de la structure électrique (4) avant et après pliage ne peut dépasser 0,5 %.

3. Composant électronique passif flexible (1) selon la revendication 1 ou la revendication 2, dans lequel la couche inorganique (2) est constituée de silicium ou de carbure de silicium ou d'arséniure de gallium ou de saphir ou de verre de quartz ou de borosilicate ou de verre.

4. Composant électronique passif flexible (1) selon l'une quelconque des revendications 1 à 3, dans lequel
le composant électronique passif flexible (1) a une longueur, une largeur et une hauteur (h1), dans lequel le produit de la longueur par la largeur est d'au plus 4 mm², de préférence d'au plus 2 mm², de manière particulièrement préférée d'au plus 1 mm².

5. Composant électronique passif flexible (1) selon l'une quelconque des revendications 1 à 4, dans lequel
la structure électrique (4) comprend au moins une piste conductrice (4b) et au moins deux plots de contact électrique (4a), les au moins deux plots de contact électrique (4a) étant connectés électriquement à la piste conductrice (4b),
de préférence, dans lequel l'au moins une piste conductrice (4b) a une largeur uniforme, la largeur n'étant pas supérieure à 5 µm et l'écart type de la largeur n'étant pas supérieur à 5 % de la largeur.

6. Composant électronique passif flexible (1) selon la revendication 5, dans lequel la piste conductrice (4b) présente un coefficient de température de résistance électrique d'au moins 3,000 ppm/K, de préférence d'au moins 3,500 ppm/ K, de manière particulièrement préférée d'au moins 3,800 ppm/K.

7. Composant électronique passif flexible (1) selon l'une quelconque des revendications 1 à 6,
comprenant en outre au moins une structure électrique supplémentaire, chacune comprenant au moins une piste conductrice,
dans lequel la structure électrique (4) et l'au moins une structure électrique supplémentaire sont disposées dans une structure multicouche de telle sorte que :
a) les pistes conductrices (4b) de la structure électrique (4) et de l'au moins une structure électrique supplémentaire sont disposées l'une au-dessus de l'autre sur des plans différents ; et
b) les pistes conductrices adjacentes (4b) superposées sont au moins partiellement séparées les unes des autres par une couche isolante supplémentaire ;
éventuellement
c) les pistes conductrices adjacentes (4b) situées l'une au-dessus de l'autre sont connectées électriquement l'une à l'autre par un ou plusieurs trous conducteurs formés à travers la couche isolante supplémentaire.

8. Composant électronique passif flexible (1) selon l'une quelconque des revendications 1 à 7, dans lequel la couche isolante (3) est constituée d'oxyde d'aluminium, de nitrure d'aluminium, d'oxyde de hafnium ou de nitrure de hafnium.

9. Composant électronique passif flexible (1) selon l'une quelconque des revendications 1 à 8, dans lequel la structure électrique (4) est constituée de platine, de nickel, d'aluminium ou d'un alliage contenant du platine, du nickel et/ou de l'aluminium.

10. Composant électronique passif flexible (1) selon l'une quelconque des revendications 1 à 9, comprenant en outre une couche de recouvrement (5) recouvrant au moins partiellement la structure électrique (4), la couche de recouvrement (5) étant formée d'une couche inorganique.

11. Composant électronique passif flexible (1) selon l'une quelconque des revendications 1 à 10, dans lequel la structure électrique (4) est conçue comme un élément chauffant.

12. Composant électronique passif flexible (1) selon l'une quelconque des revendications 1 à 11,
dans lequel la structure électrique (4) en tant qu'élément capteur présente une résistance électrique d'au moins 100 Ohm, de préférence d'au moins 1000 Ohm, de préférence d'au moins 10000 Ohm, ou
dans lequel la structure électrique (4) en tant qu'élément chauffant a une résistance électrique d'au plus 5 Ohm, de préférence d'au plus 2 Ohm, de préférence d'au plus 1 Ohm.

13. Système de composant électronique passif flexible, comprenant au moins un composant électronique passif flexible (1) selon l'une quelconque des revendications 1 à 12, et au moins une commande électrique, la commande électrique étant connectée électriquement à la structure électrique (4) et configurée pour commander le composant électronique passif flexible (1).

14. Procédé de fabrication d'un composant électronique passif flexible (1) selon l'une quelconque des revendications 1 à 12, comprenant les étapes suivantes du processus :
a) fourniture d'une plaquette inorganique (2') comportant une face supérieure (2a') et une face inférieure (2b'),
b) application d'une couche isolante (3') sur la face supérieure (2a') de la plaquette inorganique (2'),
c) application et structuration d'une structure électrique (4') ou de structures électriques multicouches sur la couche isolante (3'),
d) application d'une couche de recouvrement (5') sur la structure électrique (4'),
e) amincissement de la plaquette inorganique (2') sur la face inférieure (2b'), jusqu'à une épaisseur (t10) d'un substrat (10), comprenant la couche isolante (3) et éventuellement la plaquette inorganique (2'), d'au plus 50 um, de préférence d'au plus 35 um, de manière particulièrement préférée d'au plus 20 µm.

15. Le procédé selon la revendication 14 comprenant en outre des étapes consistant à :
f) appliquer une première couche de protection (7) sur la face de la structure électrique (4') et/ou la face inférieure (2b) du substrat (10), et éventuellement
g) retirer la première couche de protection (7) après l'étape d'amincissement de la plaquette inorganique (2').
